Europäisches Patentamt

European Patent Office

Office européen des brevets

(11) Publication number: **0 124 715**
**A1**

(12) **EUROPEAN PATENT APPLICATION**

(21) Application number: **84102531.5**

(22) Date of filing: **09.03.84**

(51) Int. Cl.³: **H 01 L 23/40**
**H 05 K 7/20**

(30) Priority: 09.05.83 US 493123

(43) Date of publication of application:
14.11.84 Bulletin 84/46

(84) Designated Contracting States:
DE FR GB IT

(71) Applicant: International Business Machines Corporation
Old Orchard Road
Armonk, N.Y. 10504(US)

(72) Inventor: David, Jack Marvin
7206 Carew Cove
Austin Texas 78759(US)

(72) Inventor: Linton, Charles Reagan
11108 Blackmoor
Austin Texas 78759(US)

(74) Representative: Colas, Alain
Compagnie IBM France Département de Propriété
Industrielle
F-06610 La Gaude(FR)

(54) Clip-fastening of a solid state device to a heatsink.

㊀ For fastening a heat generating solid state device such as
a transistor to a heatsink, a resilient U-shaped clip (81) is used.
The two opposed arms (9, 10) of the clip (81) embrace the
heatsink (21) as well as the transistors (41, 42) and urge the
latter with their tab (7) against the heatsink (21). The heatsink
can be like an elongated flat bar, and several pairs of transis-
tors (41, 42) can be arranged back-to-back. Each pair of trans-
istors is fastened by a single clip. The clip clamps them onto
the heatsink in between without using screws or other fasten-
ing means.

FIG. 4

EP 0 124 715 A1

# CLIP-FASTENING OF A SOLID STATE DEVICE TO A HEATSINK

## Technical Field

The present invention relates to an arrangement for fastening a solid state device such as a power transistor to a carrier such as a heatsink. The solid state device comprises a flat heat conducting tab which is pressed onto a flat part of the heatsink for good thermal transfer and heat dissipating purposes.

## Background Art

The field of the fastening technique of solid state devices to heatsinks is a rather elaborate one. In the following, an overview is given of that art which is believed to come closest to the subject invention.

U.S. Patents 4,204,248 and 4,259,685 show the fastening of parallelepiped power transistors, e.g. TO 220, to a carrier or heatsink by means of a screw penetrating a fastening hole in the tab of the transistor and a mounting hole in the carrier or heatsink, respectively. The screw has to be secured by a nut. Often, a flat washer and compression washer have to be used for mounting these transistors as shown on pages 8-13 of the book "Motorola Power Device Data", 2nd Ed., Motorola Inc., 1980. For fastening semi-conductor elements to a heatsink, it is known to use clips. In the cited book on pages 8-23, two different shaped clips made from spring steel are described. Those ends of the clips penetrate the heatsink through two mounting holes. When spread apart, noses on the ends of the clip come to reset on the flat heatsink and depress the semi-conductor device onto it. Obviously, the screw fastening technique is cumbersome and while the clip technique is much simpler, both of these approaches require that the heatsink has to be perforated with at least one fastening hole in each transistor mounting area.

Another form of fastening means is described in U.S. Patent 3,548,927. In accordance with this known assembly, a resilient clip is attached to a heatsink in a relatively central location surrounded by heat dissipating elements. The clip has spring elements which bear down toward a central component retaining area, and the clip is shaped in such a fashion that an electronic component can be slipped under it and there pressed by a spring clip in the direction toward the retaining area of the heat dissipating member.

U.S. Patent 4,054,901 discloses a unitary heatsink apparatus in the form of a U-shaped body of thermally conductive material adapted for use in connection with semi-conductor devices or packages having a thermally conductive transfer plate adjacent one major face of the device or package, for example a TO 220 plastic power package. One leg or the U-shaped clip urges the thermal transfer plate into intimate contact with a flat portion of the opposite leg by the spring action provided by the base of the "U". An aperture in the base of the "U" allows the leads to extend from the heatsink. Fins are included on one leg of the heatsink and means for attaching the heatsink apparatus to printed circuit boards are also provided.

U.S. Patent 3,572,428 shows a clip heatsink for use with a cylindrical thermal-pad type transistor. The clip-on heatsink is made in the form of a unitary piece of heat conductive, black-anodized spring aluminium folded on itself approximately at its center to provide an opening which fits over the transistor and tightly engages the transistor in a heat conductive relationship. The portions of the spring material form clamping jaws, with the material at the ends of the jaws being bent back to extend in substantially parallel planes along each of the converging portions beyond the bight formed by the hold at the center of the spring to provide a part of gripping extensions which can be moved toward and away from one another to spread the jaws apart to enable placement of

3

**0124715**

the heatsink clip over the transistor. In this prior art, the clip is used as heatsink itself and not as fastening means.

U.S. Patent 4,261,005 discloses a one piece stamped sheet metal heatsink put over a parallelepiped block transistor. The heatsink forming clip is kept on the transistor by its inherent spring force. Again, this arrangement is not primarily a fastening clip, but rather an extended heat dissipating tab.

Each of these aforementioned heatsinks either include a U-shaped clip incorporated as an integral part for fastening transistors themselves or are formed as a basically U-shaped clip themselves. Furthermore, each of these described heatsinks and fastening means are designed as separate individual apparatus associated with a single transistor.

### Disclosure of the invention

The main object of the present invention is to simplify the technique of fastening solid state devices comprising a flat heat conducting tab to a heatsink. Further, the device is quite simple in design and allows the use of a much simpler heatsink.

These and other objectives are accomplished in accordance with the invention basically by the use of a U-shaped clip means made from spring material. The clip means is placed over the heatsink and the solid state device so that the two opposed arms of the clip means embrace the heatsink and the solid state device and urge the latter with its heat conducting tab into intimate contact with the heatsink such that there is very little thermal resistance.

This basic solution provides an advantageously simple, reliable and inexpensive fastening scheme for mounting solid state devices to a heatsink. Furthermore, the heatsink needs no fastening  holes or the like and can therefore be of a
simple structure.

In the preferred embodiment of the invention, two solid state
devices are clamped together back-to-back by one clip means
with the heatsink in between them. The heatsink is formed of a
long, flat aluminum bar comprising tilted fins between solid
state fastening areas. Several pairs of power transistors are
arranged along a heatsink.

## Brief Description of Drawings

In the following, the invention will be described in detail in
connection   with   the   accompanying   drawing   showing   the
embodiments of the invention, in which

Figure 1 is a schematic side view showing the fastening of one
solid state device to a heatsink by one form of clip means ;

Figure  2  is  a  schematic  side  view  showing  a  pair  of
transistors  clamped  back-to-back  onto  a  heatsink  by  an
alternatively formed clip means ;

Figure 3 is a front view of the configuration shown in figure
2 ; and

Figure  4  shows  in  a  perspective  view  a  flat,  elongated
bar-like heatsink to which several pairs of transistors are
clamped on both sides.

## Best Mode for Carrying Out the Invention

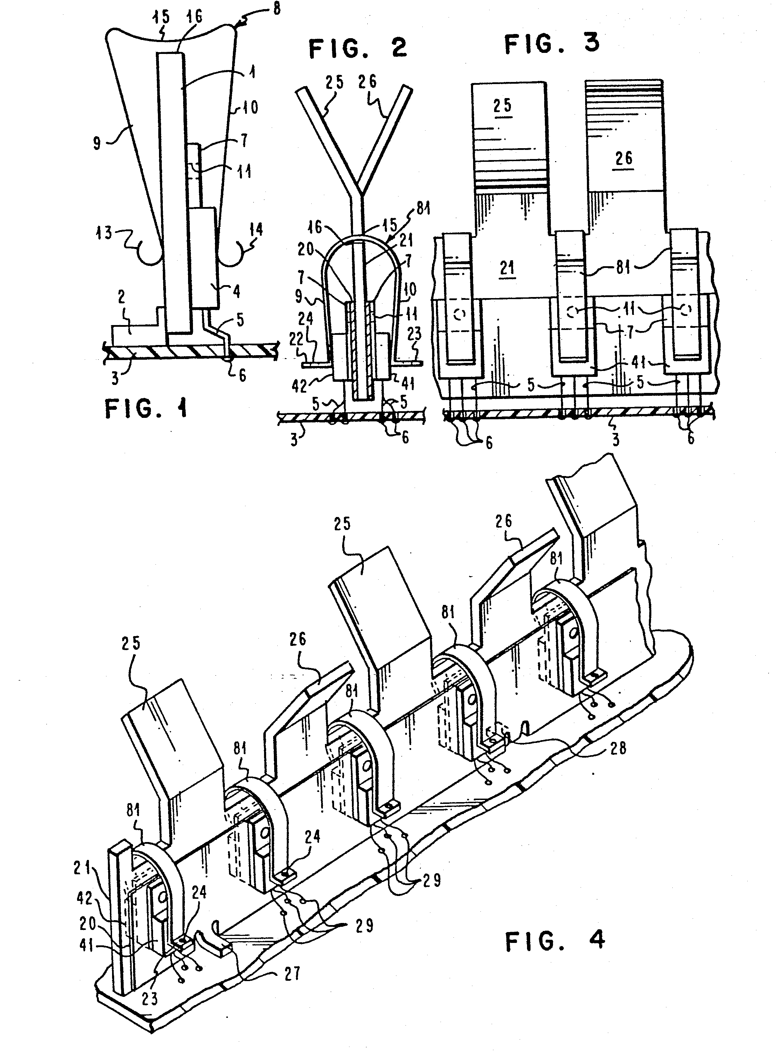

In the side-view of Figure 1, the basic solution in accordance
with  the  invention  is  depicted.  A  bar-like  heatsink  1  is
fastened  by  means  of  a  mounting  foot  2  to  a  printed  circuit
board 3.  On  one  side  of  the  heatsink  1  a  transistor  4  is
placed,  the  transistor  being  an  example  of  a  heat  generating
solid  state  device.  The  leads  5  of  the  transistor  4  pass through holes in the printed circuit board 3 and end in soldering pads 6. Transistor 4 has a flat tab 7 on its on side. This tab 7 serves to eliminate heat from transistor 4. For a better dissipation of heat, the transistor 4 with its tab 7 is pressed in intimate heat conducting contact with heatsink 1. The means for performing this pressure is a U-shaped clip 8 made from spring material such as spring steel. The two opposed arms 9 and 10 of the clip 8 embrace the heatsink 1 and the transistor 4, and urge it together with its heat conducting tab 7 onto the bar-like heatsink 1. Thus, the clip 8 serves as fastening means for mounting the transistor 4 with its heat conducting tab 7 to the heatsink 1, ensuring low thermal resistance between both while keeping the transistor 4 in place on board 3.

The shown transistor 4 has a parallel-epiped shape and may, for instance, be a type TO 220 package transistor. This is a widely used type of power transistor having a tab 7 with a mounting hole 11 in it. Normally a screw is passed through this mounting hole and through an associated opening in the heatsink and secured there by a nut. The inventive clip fastening avoids these screw, nut, and hole necessities and, furthermore, simplifies the mounting. The clip 8 is placed over the heatsink 1 and the transistor 4 with its arms 9, 10 spread apart and then released. By releasing the arms 9, 10, the inherent spring force of clip 8 urges transistor 4 with its tab 7 against the surface of the heatsink 1.

For ease of use, the ends 13, 14 of arms 9, 10 are curled up to slightly more than a half circle so that an appropriate tool can be used for putting the clip 8 in place. Furthermore, the length of the arms 9 and 10 relative to the heatsink dimension and the transistor position is chosen advantageously so that apex 15 of the clip 8 rests on the upper edge 16 of the heatsink 1, and the pressure applying parts of arms 9 and 10 rests on the most appropriate part of the casting of transistor 4. This assures that the tab 7, which underlies the casting of transistor 4 and projects from it, rests on the flat surface of the heatsink 1 in the most effective manner for maximum heat dissipation from transistor 4.

Figure 2 shows in a side-view another form of realization of the invention. In this embodiment, two transistors, 41 and 42, are arranged back-to-back including in between them a heatsink 21. The two transistors 41 and 42 are urged against this heatsink 21 by one and the same clip 81. So by only one clip, two transistors can be mounted and fastened to a heatsink in an easy manner. The shown clip 81 has a slightly different shape compared with the one shown in figure 1. The arms 9 and 10 include only one principle direction. Furthermore, the ends 22 and 23 of these arms 9, 10 are bent essentially 90° with respect to them and to the transistors 41 and 42. In each end 22 and 23, a hole 24 is provided for insertion of an appropriately formed taper-nosed pliers or the like for gripping the clip 81, for opening it, for inserting it and for releasing it during positioning over the two transistors 41 and 42. The heatsink 21 serves also as a carrier means which holds the transistors 41, 42 in place on the printed circuit board 3 so that no additional carrier means is needed.

The heatsink 21 shown in figures 2-4 is provided with fins 25, 26 in the area above those areas where no transistors 41, 42 can be mounted. These fins 25, 26 increase the effective cooling surface. They are alternately bent in an angle to both sides of the axis of the main body of the heatsink 21 so all fins 25 show to the left in figure 2 and all fins 26 to the right. Thus, when blowing a stream of cooling air along the heatsink 21 and through these V-like tilted fins 25, 26 a channeling effect is created, increasing the effectiveness of the cooling air stream. Furthermore, turbulences along the areas of the fin edges increase the cooling effect exactly in those areas where it is mustly needed, i.e., in the immediate vicinity of the transistors.

Figure 3 shows in a front view a part of heatsink 21 shown in figure 2. Figure 4 shows in a perspective view the inventive arrangement in the preferred embodiment. The heatsink 21 shown in those figures is made from a relatively thick aluminum material. Feet 27, 28 are worked out of the main body for fastening the heatsink to the printed circuit board 3. The areas between the fins 25, 26 in which transistors are to be mounted, are cut out. Finally, the fins 25 are bent to one side and fins 26 are bent to the other side, both in an appropriate angle. Transistors, preferably pairs of transistors 41 and 42, are assembled back-to-back on both sides of the heatsink 21 which is arranged upright to the surface of the printed circuit board 3. The leads 5 of the transistors are soldered to the conductors in board 3, as shown by soldering pads 19. A whole series of pairs of transistors 41, 42 can be assembled and fixed to one elongated heatsink 21 which might transverse the entire board 3.

As shown in the figures 2-4, thermal conducting insulators 20 are inserted between each transistor 41, 42 and the heatsink 21. These insulators might have the form of a long strip as depicted especially in figures 3 and 4 and cover the entire length of the bar-like heatsink 21 over an appropriate height. The thermal conducting insulator separates the transistors electrically from the heatsink and among each other. Furthermore, it serves to insure an intimate thermal contact between the tab 7 of each transistor and the surface of the heatsink 21 for establishing a transition of low thermal resistance.

The forms of the clip 81 and of the heatsink 21 as shown in figures 2-4 are especially suited to the application of an automated assembling technique which will be applied increasingly in the future.

While this invention has been particularly shown and described with reference to a preferred embodiment thereof, it will be understood by those skilled in the art that foregoing and other changes in form and detail may be made without departing from the spirit and scope of the invention.

0124715

## Claims

1. Arrangement for fastening a solid state device such as a power transistor to a carrier, especially a heatsink, the device having a flat heat conducting tab to be pressed onto a flat part of said heatsink, characterized in that it comprises :

clip means (8, 81) made from spring material clamping said device (4, 41, 42) onto the surface of said heatsink (1, 21) ;

said clip means having two opposed arms (9, 10) arranged essentially in U-shaped form ;

said arms of said clip means embracing said heatsink and said solid state device, whereby said two opposed arms due to the exerted spring force, urge said solid state device with said heat conducting tab (7) onto said heatsink for low thermal resistance.

2. Arrangement as in Claim 1, in which two solid state devices (41, 42) are arranged back-to-back with their tabs (7) and urged onto said heatsink (21) in between said tabs by said clip means (81).

3. Arrangement as in Claim 1 or 2, in which said heatsink (1, 21) is formed by a long flat bar, preferably made from aluminum.

4. Arrangement according to Claim 1, 2 or 3 in which a thin thermal conducting, insulating sheet (20) is provided between said heatsink (21) and said solid state device (41, 42).

5. Arrangement according to any one of the preceding Claims in which said solid state device has substantially the form of a parallelepiped block and is a plastic encapsulated power transistor (4, 41, 42).

6.  Arrangement as in Claim 3, in which said long flat bar is provided with elongated fins (25, 26) in those areas where no solid state devices are clamped onto said bar by said clip means.

7.  Arrangement as in Claim 6, in which said fins are alternatively tilted out of the main plane of said bar to both sides.

8.  A method of fastening a solid state device such as a power transistor to a carrier, especially a heatsink, and wherein the device has a flat heat conducting tab which is to be pressed onto a flat part of the carrier, the method being characterized in that it comprises the following steps :

    a) positioning said heat conducting tab (7) of said solid state device (4, 41, 42) essentially parallel to and in the immediate vicinity of said flat part of said heatsink (1, 21) ;

    b) placing over said solid state device and said heatsink a clip means (8, 81) with spread apart arms (9, 10) which are essentially U-shaped, opposing and made of a spring material such that it stradles both said solid state device and said heatsink ; and

    c) releasing said spread apart arms of said clip means such that due to their exerted spring force said urge said solid state device with said heat conducting tab onto said heatsink for low thermal resistance as well as for fastening it to the latter.

9.  The method of Claim 8, further including the steps of assembling back-to-back and opposite to each other solid

0124715

state devices (41, 42) on both sides of said heatsink (21) and holding them in place with a single clip means (81).

10. The method of Claim 8, further including the step of arranging, clamping, and fastening a series of said solid state devices in one row to said heatsink which is formed as a long flat bar.

11. The method of Claim 9, further including the step of arranging, clamping, and fastening a series of pairs of said solid state devices in two rows to said heatsink which is formed as a long flat bar.

FIG. 2 FIG. 3

FIG. 1

FIG. 4

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | DE-U-8 130 512  (GARDENA PRÄZISIONSTECHNIK) <br> * Claim 1 * | 1,3-5, 8,10 | H 01 L   23/40 <br> H 05 K    7/20 |
| | --- | | |
| A,D | US-A-3 572 428  (A.T. MONACO) <br> * Column  2, line 54 - column 3, line 7 * | 1 | |
| | --- | | |
| A | US-A-4 190 098  (A.G. HANLON) <br> * Column 4, lines 18-23 * | 3,10 | |
| | ----- | | |

TECHNICAL FIELDS SEARCHED (Int. Cl. 3)

H 01 L   23/40
H 05 K    7/12
H 05 K    7/20

The present search report has been drawn up for all claims

| Place of search | Date of completion of the search | Examiner |
|---|---|---|
| BERLIN | 30-04-1984 | GIBBS C.S. |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons
&　: member of the same patent family, corresponding
　　document

EPO Form 1503. 03.82